# EUROPEAN PATENT APPLICATION

(11) **EP 2 319 884 A1**
(43) Date of publication of application: **11.05.2011**
(21) Application number: 09809828.8
(22) Date of filing: 20.08.2009
(51) Int. Cl.: C08L 23/08, B29C 43/24, C03C 27/12, C08K 5/12, H01L 31/042, B29K 23/00, B29L 7/00

(54) **ETHYLENE-VINYL ACETATE COPOLYMER COMPOSITION, ETHYLENE-VINYL ACETATE COPOLYMER FILM AND METHOD FOR PRODUCING SAME**

(30) Priority: 29.08.2008 JP 2008222082
(71) Applicant: Bridgestone Corporation, Tokyo 104-0031 (JP)
(72) Inventor: SAKOJIRI Hiromichi, Yokohama-shi Kanagawa 244-8510 (JP)
(74) Representative: Lamb, Martin John Carstairs
(86) International application number: PCT/JP2009/064566
(87) International publication number: WO 2010/024176

(57) **Abstract**

[Problem to be solved]

The object of the present invention is to provide an ethylene-vinyl acetate copolymer film having excellent adhesion properties and improved film formation properties.

[Means for solving problem]

An ethylene-vinyl acetate copolymer composition comprising ethylene-vinyl acetate copolymer, a crosslinker and trimellitic acid ester, wherein the trimellitic acid ester is contained in the range of 0.01 to 3.0 part by weight based on 100 parts by weight of ethylene-vinyl acetate copolymer.

## Description

### Field of the invention

The present invention relates to an ethylene-vinyl acetate copolymer film, particularly an ethylene-vinyl acetate copolymer film suitable for a sealing film for solar cell and an intermediate film for a laminated glass.

### Description of the Related Art

An ethylene-vinyl acetate copolymer (EVA) film is excellent in transparency and adhesion properties, and hence widely used as a sealing film for solar cell and an intermediate film for a laminated glass as well as a front filter for plasma display panel (PDP).

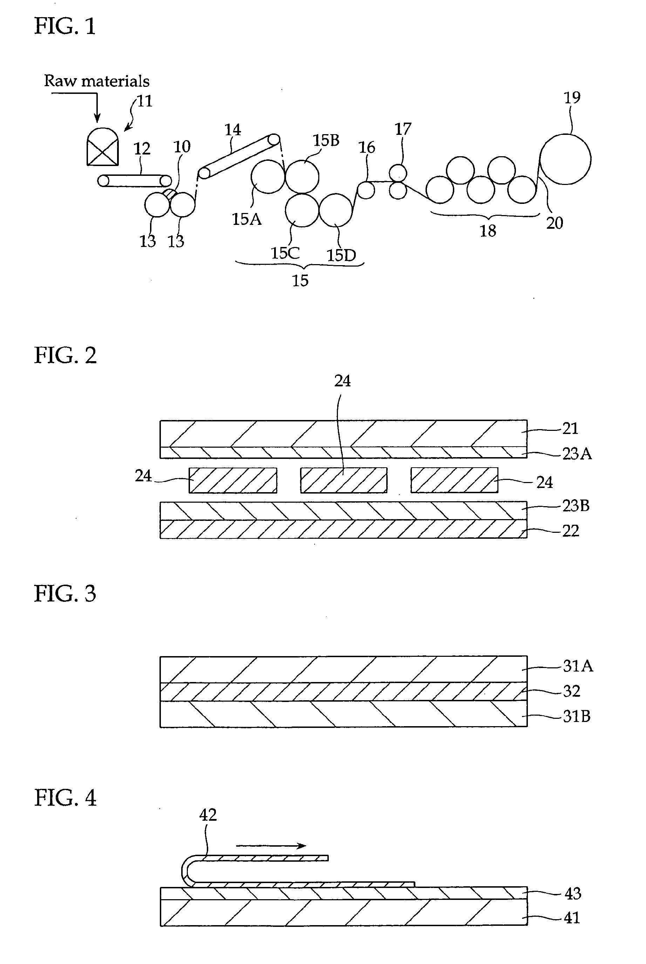

For instance, a solar cell has a structure that plural photovoltaic elements 24 (e.g., photovoltaic elements made of silicon) are sealed through a front side sealing film 23A and a backside sealing film 23B between a transparent front side protection material 21 and a backside protection material 22 (backside covering member), as shown in Fig. 2. In the solar cell, the EVA film is used as the front side sealing film 23A and the backside sealing film 23B.

The EVA film is prepared by subjecting a composition comprising ethylene-vinyl acetate copolymer and a crosslinker to film formation process. The ethylene-vinyl acetate copolymer is crosslinked by using the crosslinker, and therefore the resultant ethylene-vinyl acetate copolymer film can be enhanced in adhesion properties and durability. As the crosslinker, organic peroxides generating radical at 100°C or more are preferably used. See Patent Document 1.

The EVA composition is introduced into mixing rolls, and melted and kneaded, and then subjected to film formation process to give an EVA film. Examples of the film formation process include extrusion molding process, calender molding process, injection molding process, and hot press process. Particularly, the calender molding process is advantageously used because an EVA film having uniform thickness can be produced at high speed. The calender molding process is carried out by introducing a melted and kneaded EVA composition into heated rolls and extending the composition by application of pressure to form a film.

However, the EVA composition is apt to be stuck to heated rolls, that is, the composition shows high sticking properties to an apparatus for film formation, and therefore it is difficult to shape (mold) the composition to a film. Further even if the composition can be shaped to a film, the resultant EVA film shows poor surface smoothness.

For the reason, plasticizer or lubricant has been added to an EVA composition in order to improve the film formation properties. For example, Patent Document 1 discloses that plasticizer such as dioctyl phthalate is added to an EVA composition.

### Prior Art Documents

### Patent Document

Patent Document 1: JP(TOKKAI) 2005-29588 A

### Summary of the Invention

### Problem to be solved by the Invention

It is required that an EVA film has excellent adhesion properties as mentioned previously. However, although an EVA composition containing plasticizer or lubricant is improved in film formation properties, the resultant EVA film is apt to show reduced adhesion properties. Therefore it is demanded to further improve an EVA film.

In view of the above viewpoints, the object of the present invention is to provide an ethylene-vinyl acetate copolymer film having excellent adhesion properties and improved film formation properties.

### Means for Solving Problem

The present object is solved by the present invention, i.e., an ethylene-vinyl acetate copolymer composition comprising ethylene-vinyl acetate copolymer, a crosslinker and trimellitic acid ester,
wherein the trimellitic acid ester is contained in the range of 0.01 to 3.0 part by weight based on 100 parts by weight of ethylene-vinyl acetate copolymer.

### Effect of the Invention

The ethylene-vinyl acetate copolymer composition of the present invention contains trimellitic acid ester, whereby it is highly prevented that the EVA composition is stuck to an apparatus for film formation such as heated rolls. Hence, the ethylene-vinyl acetate copolymer composition shows excellent film formation properties. Further, by setting the contained amount of the trimellitic acid ester, which is used for reduction of sticking properties in a film formation step, to the specific range, adhesion properties of the EVA film obtained from the composition to an adherend such as a transparent substrate can be enhanced.
Hence, the present invention enables the provision of an ethylene-vinyl acetate copolymer film having excellent adhesion properties and improved film formation properties

### Brief Description of the Drawings

[Fig. 1]
   Fig. 1 is a view showing an example of a calender molding process of an EVA film according to the present invention.
[Fig. 2]
   Fig. 2 is a view explaining a solar cell in which the EVA film of the present invention is incorporated.
[Fig. 3]
   Fig. 3 is a view explaining a laminated glass in which the EVA film of the present invention is incorporated.
[Fig. 4]
   Fig. 4 is a schematic view explaining a 180° peel test method.

### Mode for Carrying out the Invention

An ethylene-vinyl acetate copolymer composition of the present invention comprises at least ethylene-vinyl acetate copolymer, a crosslinker and trimellitic acid ester as basic components. The ethylene-vinyl acetate copolymer composition may be referred to as "EVA composition".

The trimellitic acid ester of the EVA composition is contained in the range of 0.01 to 3.0 part by weight, preferably 0.1 to 1.0 part by weight, based on 100 parts by weight of ethylene-vinyl acetate copolymer. If the amount of the trimellitic acid ester is less than 0.01 part by weight, the composition is stuck to an apparatus for film formation such as heated rolls, which does not occasionally bring about sufficient film formation properties. If the amount of the trimellitic acid ester is more than 3.0 parts by weight, the resultant EVA film may not have excellent adhesion properties.

The trimellitic acid ester preferably is trimellitic acid alkyl ester. Each alkyl group of the trimellitic acid alkyl ester preferably has 1 to 12 carbon atom, especially 3 to 10 carbon atoms.

Examples of the trimellitic acid alkyl ester include trimellitic acid trimethyl ester, trimellitic acid triethyl ester, trimellitic acid tri-n-propyl ester, trimellitic acid tri-isopropyl ester, trimellitic acid tri-n-butyl ester, trimellitic acid tri-n-pentyl ester, trimellitic acid tri-n-hexyl ester, trimellitic acid tri-n-heptyl ester, trimellitic acid tri-n-octyl ester, and trimellitic acid tris(n-ethylhexyl) ester,

Of these trimellitic acid esters, trimellitic acid tri-n-octyl ester is preferred.

In the EVA composition of the invention, the content of vinyl acetate recurring unit of ethylene-vinyl acetate monomer copolymer generally is in the range of 20 to 35 parts by weight, preferably 20 to 30 parts by weight, especially 24 to 28 parts by weight based on 100 parts by weight of the ethylene-vinyl acetate monomer copolymer. Thereby the film formation properties of the EVA composition can be improved.

The EVA composition of the present invention contains a crosslinker in order to crosslink EVA and hence enhance adhesion properties and durability of the resultant EVA film.

The composition of the invention generally contains organic peroxide or photopolymerization initiator as a crosslinker. Any organic peroxides that can be decomposed at a temperature of not less than 100°C to generate radical(s) can be employed as the above-mentioned organic peroxide. The organic peroxide is selected in the consideration of film-forming temperature, conditions for preparing the composition, curing (crossliking) temperature, heat resistance of body to be bonded, storage stability. Particularly, preferred are those having a decomposition temperature of not less than 70°C, especially 80 to 120°C in a half-life of 10 hours.

From the viewpoint of the compatibility with EVA, examples of the organic peroxides preferably include tert-butylperoxy-2-ethylhexyl carbonate, 2,5-dimethylhexane-2,5-dihydroperoxide, 2,5-dimethyl-2,5-di(tert-butylperoxy)hexane-3-di-t-butylperoxide, tert-butylcumyl peroxide, 2,5-dimethyl-2,5-di(tert-butylperoxy)hexane, dicumyl peroxide, α,α'-bis(tert-butylperoxyisopropyl)benzene, n-butyl-4,4-bis(tert-butylperoxy) valerate, 1,1-bis(tert-butylperoxy)cyclohexane, 1,1-bis(tert-butylperoxy)-3,5,5-trimethylcyclohexane, tert-butyl peroxybenzoate, benzoyl peroxide, tert-butyl peroxyacetate, methyl ethyl ketone peroxide, 2,5-dimethylhexyl-2,5-bisperoxybenzoate, butylhydroperoxide, p-menthan hydroperoxide, p-chlorobenzoyl peroxide, hydroxyheptyl peroxide, chlorohexanone peroxide, octanoyl peroxide, decanoyl peroxide, lauroyl peroxide, cumyl peroxyoctoate, succinic acid peroxide, acetyl peroxide, m-toluoyl peroxide, tert-butylperoxy isobutyrate, and 2,4-dicyclobenzoyl peroxide. The organic peroxides can be used singly, or in combination of two or more kinds.

As the organic peroxide, tert-butylperoxy-2-ethylhexyl carbonate, or 2,5-di-methyl-2,5-di(tert-butylperoxy)hexane is in particular used, because the organic peroxides enable high crosslinking of EVA to enhance adhesion properties of the EVA film.

The content of the crosslinker in the EVA composition preferably is in the range of 1.0 to 5.0 part by weight, in particular 2.0 to 4.0 parts by weight based on 100 parts by weight of ethylene-vinyl acetate copolymer. Thereby, the organic peroxide enables high crosslinking of EVA to enhance adhesion properties of the EVA film.

The EVA composition of the invention preferably contains various additives such as acryloxy group-containing compounds, methacryloxy group-containing compounds and/or epoxy group-containing compounds for improvement or adjustment of various properties of the resultant EVA film (e.g., mechanical strength, adhesive property (adhesion), optical characteristics such as transparency, heat resistance, light-resistance, cross-linking rate), particularly for improvement mechanical strength.

Silane-coupling agent can be preferably used as the adhesion improver, whereby an EVA film having excellent adhesion properties can be obtained. Examples of the silane coupling agents include γ-chloropropylmethoxysilane, vinylethoxysilane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane and N-[β-(aminoethyl)-γ-aminopropyltrimethoxysilane. These silane coupling agents can be used singly, or in combination of two or more kinds.

The content of the silane coupling agent preferably is not more than 5 parts by weight, especially 0.1 to 2.0 part by weight based on 100 parts by weight of ethylene-vinyl acetate copolymer.

Examples of the acryloxy and methacryloxy group containing compounds include generally derivatives of acrylic acid or methacrylic acid, such as esters and amides of acrylic acid or methacrylic acid. Examples of the ester residue include linear alkyl groups (e.g., methyl, ethyl, dodecyl, stearyl and lauryl), a cyclohexyl group, a tetrahydrofurfuryl group, an aminoethyl group, a 2-hydroxyethyl group, a 3-hydroxypropyl group, 3-chloro-2-hydroxypropyl group. Example of the amide includes diacetone acrylamide. Further, examples of the esters include esters of acrylic acid or methacrylic acid with polyhydric alcohol such as ethylene glycol, triethylene glycol, polypropylene glycol, polyethylene glycol, trimethylol propane or pentaerythritol.

Examples of the epoxy group containing compounds include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol(ethyleneoxy)₅glycidyl ether, p-tert-butylphenyl glycidyl ether, diglycidyl adipate, diglycidyl phthalate, glycidyl methacrylate and butyl glycidyl ether.

The content of the acryloxy group-containing compounds, the methacryloxy group-containing compounds or the epoxy group-containing compounds is preferably used in the range of 0.5 to 5.0 part by weight, especially 1.0 to 4.0 part by weight based on 100 parts by weight of ethylene-vinyl acetate copolymer.

The EVA composition of the invention may contain an ultraviolet absorbent, a photostabilizer and an antioxidant additionally.

Examples of the ultraviolet absorbents include benzophenone-type ultraviolet absorbents such as 2-hydroxy-4-methoxybenzophenone, 2-hydroxy-4-n-dodecyloxybenzophenone, 2,4-dihydroxybenzophenone, 2,2'-dihydroxy-4-mthoxybenzophenone, and 2-hydroxy-4-n-octoxybenzophenone, to which examples are not particularly restricted. The content of the benzophenone-type ultraviolet absorbent preferably is in the range of 0.01 to 5 part by weight based on 100 parts by weight of ethylene- ethylene-vinyl acetate copolymer.

As the photostabilizer, preferred is hindered amine photostabilizer. The examples include LA-52, LA-57, LA-62, LA-63, LA-63p, LA-67 and LA-68 (each manufactured by ADEKA Co., Ltd.), Tinuvin 744, Tinuvin 770, Tinuvin 765, Tinuvin 144, Tinuvin 622LD, and CHIMASSORB 944LD (each manufactured by Ciba Specialty Chemicals Co., Ltd.), and UV-3034 (each manufactured by B. F. Goodrich). The photostabilizers can be each used singly, or in combination of two or more kinds. The content of the photostabilizer preferably is in the range of 0.01 to 5 part by weight based on 100 parts by weight of ethylene-vinyl acetate copolymer.

Examples of the antioxidants include hindered phenol-type antioxidants such as N,N'-hexan-1,6-diyl-bis[3-(3,5-di-tert-butyl-4-hydroxyphenyl) propionamide], phosphorus-type heat stabilizers, lactone-type heat stabilizers, vitamin E-type heat stabilizers and sulfur-type heat stabilizers.

In order to obtain an EVA film from the EVA composition, a process comprising melting and kneading the EVA composition and then shaping (molding) the kneaded composition to form a film can be used.

For example, the EVA film can be formed by introducing the EVA composition into mixing rolls at a material feed opening such as a hopper to melt and knead the composition, and then extruding the kneaded composition in the form of film through an extruder or subjecting the kneaded composition to press working to form a film. Otherwise, the EVA film can be formed, for example, by introducing the EVA composition into calender rolls, whereby the composition is melted and kneaded and continuously the kneaded composition is processed to a film. Further, in the other process, the EVA film can be formed by introducing the resin composition into a kneading extruder such as twin-screw extruder to melt and knead the composition, and then extruding the kneaded composition in the form of film.

Of these processes, preferred is a process for forming an EVA film by melting and kneading the EVA composition and then subjecting the kneaded composition to calender molding. When a conventional EVA composition is subjected to calender molding, the composition is apt to be stuck to the calendering roll heated. Therefore, in case the EVA composition of the invention is subjected to calender molding, the effect of the present invention can be advantageously obtained.

An example of processes for the preparation of an EVA film from the EVA composition of the invention by means of calender molding is shown in Fig. 1. An EVA composition (raw materials) is introduced into a kneader 11 and kneaded under melting, and then the kneaded composition 10 is transported by a conveyer 12 to be introduced into mixing rolls 13. The kneaded composition 10 molded in the form of film by the mixing rolls 13 is transformed by a conveyer 14, and rolled (smoothed) by calender rolls 15 (a first roll 15A, a second roll 15B, a third roll 15C, a forth roll 15D), and then the resultant rolled film is taken out by a take-off roll 16. Thereafter, the surface of the rolled film is cooled by five cooling rolls 18 to prepare a film 20, which is rewound around a winder 19. Thereafter, the EVA film may be cut in the predetermined size, if necessary.

The melting and kneading of the EVA composition is preferably carried out at temperature of 50 to 90°C, especially 55 to 70°C. The time period for the melting and kneading is preferably in the range of 1 to 30 minute, especially 5 to 15 minutes. Thereby, the EVA composition can be appropriately melted such that the composition is not stuck to a film forming apparatus such as calender rolls.

In case the EVA composition melted and kneaded is molded to a film by calender molding, the used calendering roll is preferably heated to temperature of 50 to 90°C, especially 55 to 70°C. Thereby, it is highly prevented to stick the EVA composition to the calendering roll.

The speed of rotation of calender rolls preferably is in the range of 1 to 30m/min., especially 1 to 20m/min.

The thickness of the EVA film generally is in the range of 50µm to 2mm, though it is determined depending on the use.

The EVA film of the invention, which is obtained by subjecting the EVA composition to film-formation process, is excellent in film-formation properties, and hence the film has excellent surface smoothness and uniform thickness. Further, the EVA film shows improved adhesion to a transparent substrate such as a plastic substrate or glass plate, and therefore it is preferred to use the film as an adhesive film.

Examples of the uses (intended uses) of the EVA film include a sealing film for solar cell, an intermediate film for laminated glass and an adhesive film for optical filter. The conventional EVA film shows poor adhesion to a plastic film for a transparent substrate. Therefore, when the EVA film of the invention is used as an adhesive film for adhesion to the plastic film, the effect of the invention can be advantageously exerted. Hence, it is particularly preferred to use the EVA film of the invention as a sealing film for solar cell, in which plastic films are widely used as a protective member.

The solar cell in which the EVA film is incorporated has, for example, the structure that a transparent front side protection material, a backside protection material and photovoltaic elements sealed therebetween by a sealing film are combined with each other by crosslinking of the sealing film, the sealing film being the EVA film of the invention, though the structure is not restricted.

In the solar cell, the sealing film is crosslinked for sealing photovoltaic elements. The crosslinked (cured) EVA film of the invention shows excellent adhesion properties.

In order to sufficiently sealing photovoltaic elements, in general, a transparent front side protection material 21, a front side sealing film 23A, photovoltaic elements 24 (e.g., photovoltaic elements made of silicon), a backside sealing film 23B and a backside protection material 22 are superposed in order to obtain a laminate, and then the sealing films are crosslinked or cured in the usual manner; for example, by application of heat and pressure, as shown in Fig. 2.

The crosslinking or curing is preferably carried out to have highly sealing properties until the gel fraction of the sealing film attains 80% by weight or more. In order to crosslink or cure a sealing film to have the gel fraction, for example, the laminate mentioned above is pressed under heating using a vacuum laminator under the conditions of temperature of 135 to 180°C, more preferably 135 to 180°C, especially 155 to 180°C, degassing time of 0.1 to 5min., pressure of 0.1 to 1.5kg/cm², and pressing time of 5 to 15min.

In the solar cell, the EVA film of the invention can be used for at least one of front side and backside sealing films.

In the invention, a side receiving a light with respect to the photovoltaic elements is referred to as "front side", whereas a side opposite to the "front side" is referred to as "backside".

The transparent front side protection material used in the solar cell of the invention generally is a glass plate such as silicate glass. A thickness of the glass plate is generally in the range of 0.1 to 10 mm, preferably 0. 3 to 5 mm. The glass plate is tempered in heat or chemical resistance.

The backside protection material of the invention generally is a plastic film (e.g., PET film). However, fluorinated polyethylene film (polyfluoroethylene film) or a plastic film having silver-deposited layer thereon, especially a laminated film of fluorinated polyethylene film/Al/fluorinated polyethylene film is also preferred from the viewpoint of heat resistance.

In the next oplace, a laminated glass in which the EVA film is incorporated has, for example, the structure that an intermediate film 32 is interposed between two glass plates 31A, 31B, and combined with each other, the intermediate film 32 being the EVA film of the invention, as shown in Fig. 3.

In order to prepare the laminated glass, for example, an intermediate film is interposed between two transparent substrates to give an unpressed laminate, and the unpressed laminate is degassed, and then pressed under heating. The pressing under heating brings about crosslinking or curing of EVA film whereby the film and the transparent substrates are combined with each other.

In the preparation of the laminated glass, the pressing under heating is generally carried out by, for example, preliminarily pressing under heating the unpressed laminate at a temperature of 80 to 120°C and then heating it at a temperature of 100 to 150°C (especially approx. 130°C) for 10 minutes to one hour. The crosslinked laminate is generally cooled at room temperature. The cooling is preferably conducted rapidly.

In the invention, the "glass" of the laminated glass means an overall transparent substrate, and hence the "laminated glass" means one obtained by interposing an intermediate film between transparent substrates.

As materials of the transparent substrate, glass plates such as silicate glass plate, inorganic glass plate and color free transparent glass plate, as well as polyethylene terephthalate (PET) film, polyethylene naphthalate (PEN) film or polyethylene butyrate film can be used, though the transparent substrate is not restricted to them. Especially preferred is PET film. The thickness of the transparent substrate preferably is in the range of 0.05 to 20mm.

The transparent substrates located on the both sides of the intermediate film may be identical or may be structured by combined use of different substrates. The combination of the transparent substrates is preferably determined in view of the strength of the transparent substrate and the use of the laminated glass.

In case the laminated glass of the invention has a glass plate in one side and a plastic film in the other side as the transparent substrates, the laminated glass can be designed so as to have moderate penetration resistance, impact resistance and transparency. Therefore the laminated glass can be used in a glass of a window glass equipped in building and various vehicles, or a glass of a showcase for display, or a glass of show window.

In case the laminated glass of the invention has glass plates in both sides as the transparent substrates, the laminated glass can be designed so as to have particularly improved impact resistance and penetration resistance. Therefore the laminated glass can be used in various uses including a laminated glass

In the laminated glass (film-reinforced glass) having a plastic film in one side, which is, for example, used in a side window or inserted glass of automobile, the plastic film need not have the thickness of windshield and therefore its thickness is generally in the range of 0.02 to 2 mm, preferably 0. 02 to 1.2 mm. The thicknesses of the intermediate film and plastic film are varied depending on where the laminated glass is used.

The glass plate of the invention generally is silicate glass. In the film-reinforced glass, the thickness of the glass plate is varied depending on where the film-reinforced glass of the invention is used. For example, in case the film-reinforced glass is used as a side window or inserted glass of automobile, the glass plate need not have the thickness of windshield and therefore its thickness is generally in the range of 0.1 to 10 mm, preferably 0. 3 to 5 mm. The above-mentioned one glass plate is tempered in heat or chemical resistance.

In the laminated glass of the invention having glass plate in both sides, which is suitable for a windshield of automobile, the thickness of the glass plate generally is in the range of 0.5 to 10mm, preferably 1 to 8mm.

In case a plastic film is used as a transparent substrate of the laminated glass of the invention, the plastic film preferably has a hard coat layer thereon, whereby the laminated glass can acquire abrasion-resistant

### EXAMPLE

The invention is illustrated in detail using the following Examples. The invention is not restricted by the following Examples.

### [Example 1]

An EVA composition composed of raw materials shown in the following formulation was fed to a roll mill, and kneaded under melting at 60°C for 10 minutes, and then subjected to calender molding to prepare an EVA film (thickness: 0.4mm). In the calender molding, the calendering rolls were heated to 64°C and had speed of rotation of 10m/min.

| Formulation of EVA composition: | |
|---|---|
| Ethylene-vinyl acetate copolymer (content of vinyl acetate based on 100wt. parts of EVA: 28 wt. parts): | 100 weight parts |
| Crosslinker (tert-butylperoxy-2-ethylhexylcarbonate): | 3 weight parts |
| Crosslinking auxiliary (triallyl isocyanurate): | 2 weight parts |
| Silane coupling agent (3-methacryloxypropyl trimethoxy silane): | 0.5 weight part |
| Lubricant (trimellitic acid tri-n-octyl ester): | 0.01 weight part |

### [Examples 2-5 and Comparison Examples 1 and 2]

The procedures of Example 1 were repeated except for using lubricant and the content shown in Table 1.

### [Comparison Examples 3 and 4]

The procedures of Example 1 were repeated except for using polyoxyethylene alkyl ether phosphoric acid ester as lubricant.

### (Evaluation)

The EVA films obtained above are evaluated according to the following procedures.

### 1. Sticking properties to roll

When the melted and kneaded EVA composition is subjected to the rolling processing using calender rolls, the melted and kneaded EVA composition located on the calender roll is cut to form an incision of 10cm. The melted and kneaded EVA composition is peeled from the calender roll by using the incision, and the peeling force is measured with a push-pull gage (Digital Force Gage ZP-500N, available from IMADA CO., Ltd.). The measured value is used for evaluation of sticking properties to roll (N/10cm). The reduction of the value (i.e., sticking properties to roll) means more improvement of film-formation properties.

### 2. Adhesion properties

Adhesion properties between the EVA film and PET film are evaluated according to 180° peel test (IIS K 6854, 1994). The 180° peel test is carried out in the following manner as shown in Fig. 4.

An EVA film 43 and a PET film (thickness: 0.05mm) 42 are superposed in this order on a glass plate (thickness: 2.5mm), and the resultant laminate is degassed in vacuum by using a vacuum laminator, and then preliminarily bonded under pressure at 90°C. Thereafter, the laminate is placed in an oven and subjected to heat treatment at temperature of 110°C for 30 minutes. Subsequently, the laminate is allowed to stand in an atmosphere of 23°C and 50%RH for 24 hours. Then, a part of the PET film 42 is peeled from the EVA film 43 and the PET film 42 is turned up at 180°, and then pulled at tensile rate of 100mm/min. by using a tensile tester (Autograph, available from Shimadzu Corporation) to measure the peeling force as adhesion to PET (N/cm).

**[Table 1]**

| | | **Example** | | | | | **Comparison Example** | | | |
|---|---|---|---|---|---|---|---|---|---|---|
| | | 1 | 2 | 3 | 4 | 5 | 1 | 2 | 3 | 4 |
| **Formulation** (part by weight) | EVA | 100 | 100 | 100 | 100 | 100 | 100 | 100 | 100 | 100 |
| | Crosslinker | 3.0 | 3.0 | 3.0 | 3.0 | 3.0 | 3.0 | 3.0 | 3.0 | 3.0 |
| | Crosslinking auxiliary | 2.0 | 2.0 | 2.0 | 2.0 | 2.0 | 2.0 | 2.0 | 2.0 | 2.0 |
| | Silane Coupling agent | 0.5 | 0.5 | 0.5 | 0.5 | 0.5 | 0.5 | 0.5 | 0.5 | 0.5 |
| | Lubricant (trimellitic acid tri-n-octyl ester) | 0.01 | 0.1 | 0.3 | 1.0 | 3.0 | 0.0 | 5.0 | 0.0 | 0.0 |
| | Lubricant (polyoxyethylene alkyl ether phosphoric acid ester) | 0.0 | 0.0 | 0.0 | 0.0 | 0.0 | 0.0 | 0.0 | 0.1 | 1.0 |
| **Evaluation** | Sticking force to roll (N/10cm) | 3.4 | 2.7 | 2.2 | 1.4 | 1.0 | 7.3 | 0.5 | 3.1 | 1.8 |
| | Adhesion to PET (N/cm) | 8.3 | 10.8 | 12.4 | 12.6 | 9.1 | 8.0 | 6.2 | 7.5 | 5.6 |

As shown in Table 1, the EVA films of Examples 1 to 5 have reduced sticking force and hence excellent film-formation properties. Further, the EVA films of Examples 1 to 5 show excellent adhesion to PET. Thus, it is apparent that the EVA films are suitable for an adhesive film to a transparent substrate.

### Explanations of letters or numerals

- 11: Kneader
- 12: Conveyer
- 13: Mixing rolls
- 14: Conveyer
- 15: Calender rolls
- 15A, 15B, 15C, 15D: Calender roll
- 16: Take-off roll
- 18: Cooling rolls
- 19: Winder
- 20: EVA film
- 21: Transparent front side protection material
- 22: Backside protection material
- 23A, 23B: EVA film
- 24: Photovoltaic element
- 31A, 31B: Transparent substrate
- 32: Intermediate film for laminated glass
- 41: Glass plate
- 42: PET film
- 42: EVA film

## Claims

1. An ethylene-vinyl acetate copolymer composition comprising ethylene-vinyl acetate copolymer, a crosslinker and trimellitic acid ester,
wherein the trimellitic acid ester is contained in the range of 0.01 to 3.0 part by weight based on 100 parts by weight of ethylene-vinyl acetate copolymer.

2. An ethylene-vinyl acetate copolymer composition as defined in claim 1, wherein the trimellitic acid ester is trimellitic acid alkyl ester.

3. An ethylene-vinyl acetate copolymer composition as defined in claim 2, wherein the trimellitic acid alkyl ester has an alkyl group having 1 to 12 carbon atom.

4. An ethylene-vinyl acetate copolymer composition as defined in any of claims 1 to 3, wherein the crosslinker is contained in the range of 1.0 to 5.0 part by weight based on 100 parts by weight of ethylene-vinyl acetate copolymer.

5. An ethylene-vinyl acetate copolymer film obtained by film formation of the composition as defined in any of claims 1 to 4.

6. A process for the preparation of an ethylene-vinyl acetate copolymer film comprising melting and kneading the composition as defined in any of claims 1 to 4, and then molding the kneaded composition to form a film.

7. A process for the preparation of an ethylene-vinyl acetate copolymer film comprising melting and kneading the composition as defined in any of claims 1 to 4, and then molding the kneaded composition by means of calender molding to form a film.

8. A process for the preparation of an ethylene-vinyl acetate copolymer film as defined in claim 7, wherein calender rolls used in the calender molding are heated to a temperature of 55 to 90°C.

9. An ethylene-vinyl acetate copolymer film obtained by the process as defined in any of claims 6 to 8.

10. A solar cell comprising a transparent front side protection material, a backside protection material and photovoltaic elements sealed therebetween by a sealing film, these being combined with each other by crosslinking of the sealing film,
wherein the sealing film is the ethylene-vinyl acetate copolymer film as defined in claim 5 or 9.

11. A laminated glass comprising two transparent substrates and an intermediate film therebetween, the transparent substrates and the adhesive being integrated by curing of the film,
wherein the intermediate film is the ethylene-vinyl acetate copolymer film as defined in claim 5 or 9.
